# EUROPEAN PATENT SPECIFICATION

(11) **EP 0 461 269 B1**
(45) Date of publication and mention of the grant of the patent: **01.03.1995**
(21) Application number: 91901550.3
(22) Date of filing: 26.12.1990
(51) Int. Cl.: H05B 6/68

(54) **HIGH-FREQUENCY HEATING DEVICE**
HOCHFREQUENZHEIZGERÄT
DISPOSITIF CHAUFFANT A HAUTE FREQUENCE

(30) Priority: 29.12.1989 JP 340648/89; 28.02.1990 JP 47567/90; 17.07.1990 JP 188941/90
(43) Date of publication of application: 18.12.1991
(73) Proprietor: MATSUSHITA ELECTRIC INDUSTRIAL CO., LTD., Kadoma-shi, Osaka-fu, 571 (JP)
(72) Inventor: YOSHINO, Koji 4-406, Takanoharaekinishidanchi, Soraku-gun Kyoto 619-02 (JP); KASHIMOTO, Takashi, Nara-shi Nara 630 (JP); YAMAGUCHI, Kimiaki, Nara-shi Nara 630 (JP); YOUTA, Masato, 6, Jingu 1-chome Nara-shi Nara 631 (JP); SAKAI, Shinichi, Yamatokoriyama-shi Nara 639-11 (JP); MORIYAMA, Satomi, Nara-shi Nara 630 (JP)
(74) Representative: Eisenführ, Speiser & Partner
(86) International application number: PCT/JP90/01703
(87) International publication number: WO 91/10338

(56) References cited:
- EP-A- 0 467 224
- JP-A- 1 304 688
- JP-A- 5 286 545
- JP-A-57 128 057
- JP-A-62 216 409
- JP-B- 5 641 001
- US-A- 4 211 911

## Description

The present invention relates to a high-frequency heating apparatus in which state of a food is estimated by detecting state of electromagnetic wave in a heating chamber such that operation of devices is controlled.

### [BACKGROUND OF THE INVENTION]

In recent years, trend that unfreezing of foods by the use of high-frequency heating apparatuses is automated becomes predominant. Conventionally, such a procedure has been usually taken in which weight of a food is inputted by keys in automatic timing or is measured by using a weight sensor for automatically detecting weight of the food such that the food is heated for a corresponding one of optimum heating periods preset for weights of foods, respectively.

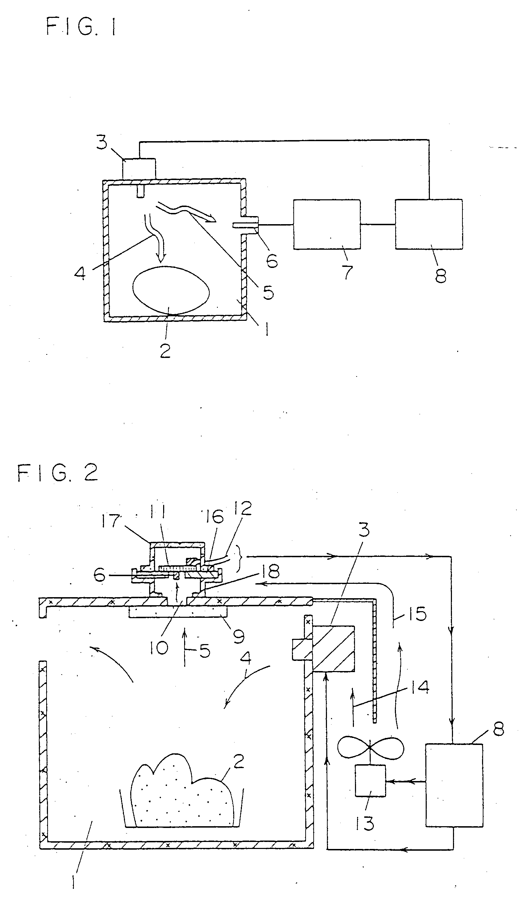

Furthermore, Japanese Patent Publication No. 52-2133 (which discloses an apparatus having the features defined in the preamble of claim 1) proposes that a microwave detecting element, namely, an antenna is disposed in a heating chamber so as to utilize such a characteristic that electric power of microwave detected by the microwave detecting element without being absorbed by a food is inversely proportional to weight of the food. Hereinbelow, its arrangement is described with reference to Fig. 1. A frozen food 2 is placed in a heating chamber 1 and wave 4 is irradiated over the food 2 from a wave irradiator 3. At this time, a portion 5 of the wave, which has not been absorbed by the food 2, is detected by an antenna 6 mounted in the heating chamber 1 and then, is subjected to detection by a detection circuit 7 so as to be delivered to a controller 8. Since quantity of the wave detected by the antenna 6 is inversely proportional to weight of the food 2, weight of the food 2 can be judged reversely and thus, its optimum heating period can be set.

However, in the known high-frequency heating apparatus referred to above, in the case where state of wave in the heating chamber is detected by using the antenna and the detection circuit in order to detect state of the food in the heating chamber, detection level changes greatly according to construction of the antenna, construction of the detection circuit, mounting accuracy of the antenna and the detection circuit, influence of external magnetic field, etc. Thus, such a problem arises that this constitutes an extremely unstable factor in determination of subsequent sequences through estimation of weight of the food, etc.

### [DISCLOSURE OF THE INVENTION]

The present invention eliminates such conventional drawbacks and has for its object to provide an optimum finished state of cooking in which control of devices based on detection of state of electromagnetic wave by the use of an antenna and a detection circuit is performed remarkably stably.

In order to accomplish this object, there is provided a high-frequency heating apparatus according to claim 1.

Further embodiments of the invention are defined by the dependent claims.

### [BRIEF DESCRIPTION OF THE DRAWINGS]

Fig. 1 is a view showing an arrangement of a prior art high-frequency heating apparatus provided with an antenna;
Fig. 2 is a view showing an arrangement of a high-frequency heating apparatus according to one embodiment of the present invention;
Fig. 3 is a view showing an arrangement of a main portion of the high-frequency heating apparatus of the present invention;
Fig. 4 is a view showing an arrangement of one embodiment of its antenna;
Fig. 5 is a view showing an arrangement of one embodiment of its detection circuit;
Fig. 6 is a view showing an equivalent circuit of the detection circuit;
Fig. 7 is a characteristic diagram showing temperature of a food and degree of absorption of wave;
Fig. 8 is a characteristic diagram showing optimum relation between temperature of a food and output of the detection circuit;
Fig. 9 is a characteristic diagram showing optimum relation between weight of a food and output of the detection circuit; and
Fig. 10 is a characteristic diagram showing relation between input and output of the detection circuit based on temperature as a parameter.

### [BEST MODE FOR WORKING THE INVENTION]

Fig. 2 is a sectional view showing an arrangement of a high-frequency heating apparatus according to one embodiment of the present invention. Wave 4 is irradiated over a food 2 placed in a heating chamber 1 from a wave irradiator 3. At this time, a portion 5 of the wave, which includes reflected wave, penetrates through a resinous slit cover 9 in accordance with state of the food 2 so as to pass through a slit 10 formed on a wall of the heating chamber 1 and is detected by an antenna 6 which is formed by copper foil provided on one face of a printed board 11. The portion 5 of the wave is transmitted to a detection circuit 7 provided on the other face of the printed board 11 so as to be subjected to detection and then, is delivered, as a detection circuit output, to a controller 8 by a lead wire 12. In accordance with amount of detection, the controller 8 finds state of the food 2 and judges an optimum unfreezing period so as to control operation of the wave irradiator 3 and a fan 13. A large portion 14 of cool air from the fan 13 is drawn to the wave irradiator 3, while a portion 15 of the cool air is guided to the printed board 11 having the antenna 6 and the detection circuit 7.

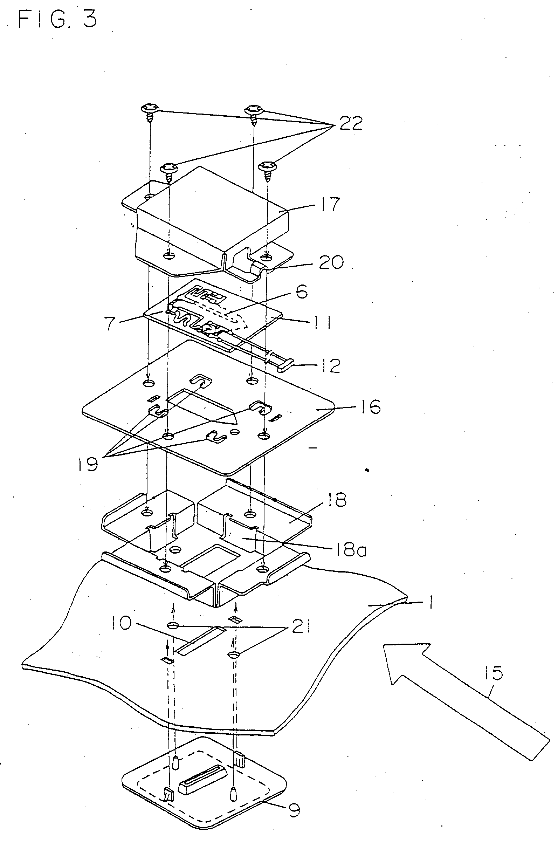

The printed board 11 is formed by a double-sided board in which copper foil is applied to opposite faces of a board made of ethylene tetrafluoride resin or glass epoxy resin. One face of the printed board 11 acts as a signalling face so as to form the detection circuit 7, while the other face of the printed board 11 acts as a grounding face such that a strip circuit is formed between the signalling face and the grounding face. The antenna 6 is formed on the grounding face and the printed board 11 is soldered to a metal plate 16 by using the grounding face. A metal cover 17 for protecting the detection circuit 7 from external noises is mounted by using the metal plate 16. The lead wire 12 is gripped between the metal plate 16 and the metal cover 17 so as to be fixed in position such that an integral structure is formed. Furthermore, by using machine screws, the metal plate 16 and the metal cover 17 are fastened together to a metal support 18 spot welded to the wall of the heating chamber 1. As shown in Fig. 3, the support 18 has ventilation openings 18a for passing therethrough the portion 15 of wind from the fan 13.

Fig. 3 is a fragmentary perspective view showing one example of a mounting arrangement on the wall of the heating chamber 1. The grounding face of the printed board 11 having the antenna 6 and the detection circuit 7 provided on its opposite faces, respectively is soldered to four convex portions 19 of the metal plate 16. The printed board 11 is covered from above by the metal cover 17 for intercepting wave. Then, while the lead wire 12 is being gripped between a lead wire clamp 20 of the metal cover 17 and the metal plate 16 so as to be fixed, the metal plate 16 and the metal cover 17 are fastened together to the metal support 18 with machine screws 22 through positioning on the wall of the heating chamber 1 by the use of positioning holes 21. In this arrangement, an earth of the printed board 11, namely an earth of the detection circuit 7 can be positively obtained by soldering the printed board 11 to the metal plate 16. Meanwhile, the metal plate 16 and the metal support 18 are securely short-circuited by fastening of the machine screws 22, while the metal support 18 and the wall of the heating chamber 1 are reliably short-circuited by welding. Therefore, mounting accuracy is excellent for microwave and earthing is reliable. Since stress caused by fastening of the machine screws is absorbed by the metal plate 16, stress to the detection circuit 7 can be restricted.

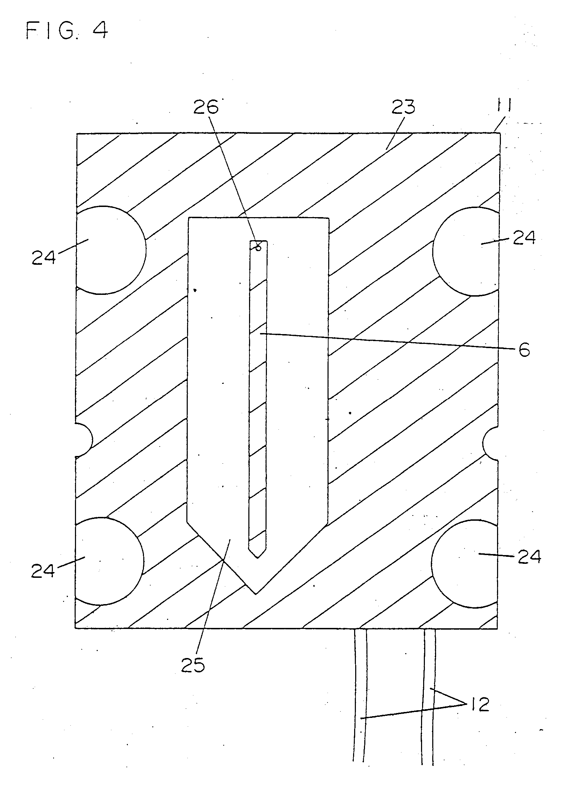

Fig. 4 shows the printed board 11 as observed from the antenna 6. In the antenna 6 and the grounding surface 23, resist coating is performed on the surface of the copper foil. On the other hand, a soldering face 24 is electrically short-circuited to the grounding face 23 but does not have the coating so as to be easily soldered to the metal plate 16. Meanwhile, a periphery 25 of the antenna has neither the copper foil nor the coating and thus, material of the board is exposed. Wave detected by the antenna 6 is adapted to be delivered to the detection circuit 7 on the rear face via a through-hole 26. The coating is used for stabilizing detection performance through protection of the surface of the copper foil.

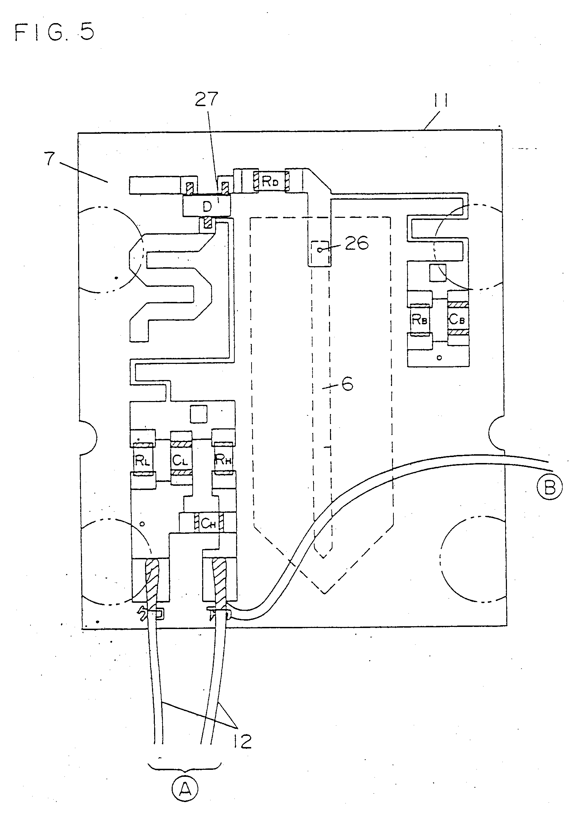

Fig. 5 shows the printed board 11 as observed from the detection circuit 7. In Fig. 5, broken lines and one-dot chain lines indicate the arrangement of the side of the antenna 6 of Fig. 4. Wave delivered from the antenna 6 is guided to the detection circuit 7 via the through-hole 26 and is subjected to detection by the detection circuit 7 which is constituted by a microstrip line employing chip parts such as a diode 27 and the copper foil. When the wave is fetched from the lead wire 12, the wave in a state of direct current is transmitted. In accordance with the present invention, the lead wire 12 is fixed at a location A of Fig. 5 through guide of the lead wire clamp 20 of the metal cover 17. However, if the lead wire 12 is not clamped as in prior art, the lead wire 12 may be positioned at a location B. Since the lead wire 12 made of metal comes close to the antenna 6 through the board acting as, so to speak, an intermediary, such phenomena may happen that impedance obtained at the time when the antenna 6 is observed from interior of the heating chamber 1 changes greatly and electromagnetic wave is carried by the lead wire 12 itself. Therefore, if the lead wire 12 is fixed in position without being set free, remarkable stabilization can be effected.

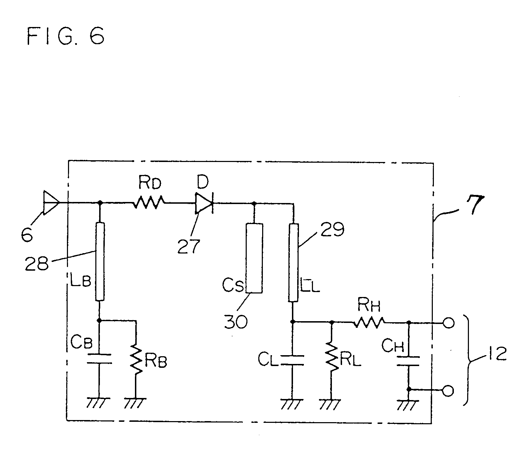

Fig. 6 is a view of an arrangement of an equivalent circuit showing one example of the detection circuit 7. Electric power obtained from the antenna 6 is subjected to detection by the diode 27, integrated and filtered by a low-pass filter so as to be delivered, as a detection output, to the controller 8. In the case where the detection circuit 7 is formed on the double-sided board, inductances 28 and 29 for the low-pass filter and a capacitance 30 for integration can be constituted by a microstrip line.

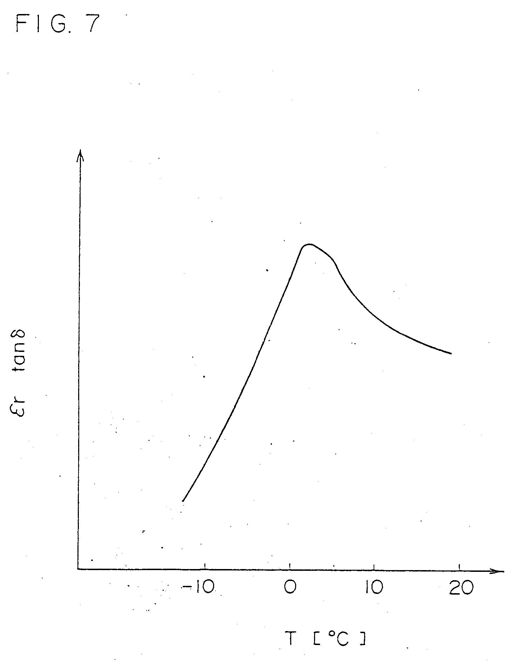

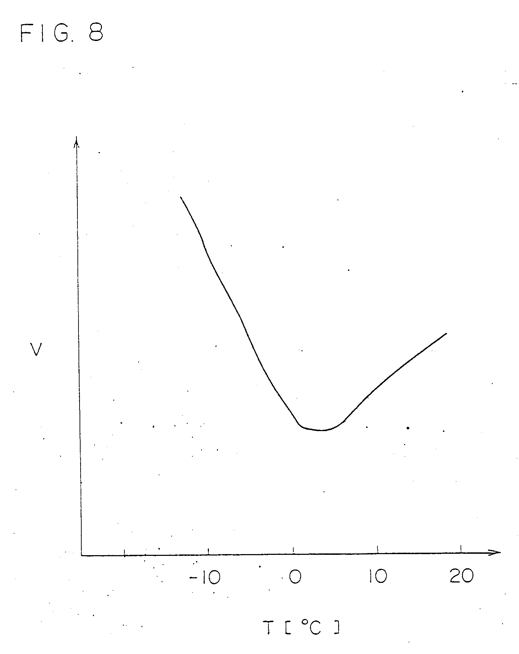

Figs. 7 to 9 are characteristic views indicative of a detection principle of unfreezing in the high-frequency heating apparatus of the present invention. The detection principle is described here. When a food is uniformly heated such that temperature of whole of the food rises simultaneously, product of specific inductive capacity εᵣ and dielectric loss tanδ changes as shown in Fig. 7. In Fig.7, the abscissa indicates temperature of the food, while the ordinate indicates (εᵣ·tanδ). (εᵣ·tanδ) is an index for indicating how readily the food absorbs wave and shows that the food is less likely to absorb wave in a frozen state of the food but is likely to absorb wave in the vicinity of 0 °C. In other words, wave detected by the antenna without being absorbed by the food is large in quantity in a frozen state of the food but becomes small in quantity in the vicinity of 0 °C. Fig. 8 is obtained from this. In Fig. 8, the abscissa indicates temperature of the food, while the ordinate indicates output of the detection circuit. As will be seen from Fig. 8, when the food exhibits uniform rise of temperature, it is considered possible to detect unfreezing at a point of inflection (minimum value) of detection output. However, actually, heating by the high-frequency heating apparatus is nonuniform and has combination of locations where wave is concentrated and locations where wave is not concentrated. Thus, since a wave form in which a number of curves of Fig. 8 overlap each other is obtained, it is impossible to simply judge completion of unfreezing at the point of inflection.

Hence, an initial value and an initial change rate of output of the detection circuit are actually effective for detecting unfreezing. The initial value is approximately inversely proportional to weight of the food. For example, in the case where the food is small in amount, absorption of wave is small and thus, initial output of the detection circuit is large. On the other hand, in the case where the food is large in amount, absorption of wave is large and thus, initial output of the detection circuit is small. Meanwhile, in the case of the food of low temperature of, for example, -20 °C and the food of intermediate temperature of, for example, -10 °C, there is such a trend in which the initial change rate of output of the detection circuit is large and small, respectively.

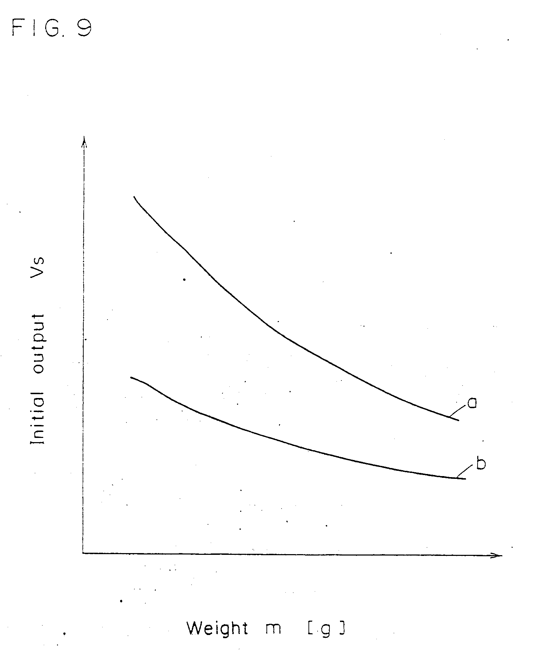

From the above principle, relation between weight of the food and initial output is obtained as shown in Fig. 9 by using the initial change rate as a parameter such that weight and initial temperature of the food are judged. In Fig. 9, the curve a indicates the food of low temperature having large initial change rate, while the curve b indicates the food of intermediate temperature having small initial change rate. Needless to say, by cooking through setting of an optimum heating period for each weight and each initial temperature in the controller 8, remarkably stable detection of unfreezing is achieved through comparison with a weight sensor which may make erroneous decisions due to weight of a dish.

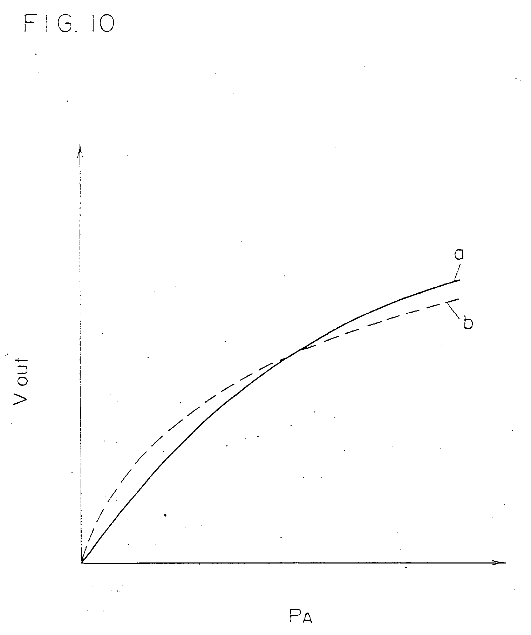

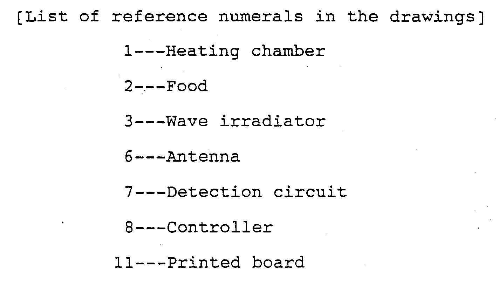

Fig. 10 is a characteristic view showing one example of temperature drift of input/output characteristics of the detection circuit. The abscissa indicates input P_{A} of the detection circuit, i.e. quantity of wave detected by the antenna, while the ordinate indicates output Vout of the detection circuit. Usually, in the detection circuit having the input/output characteristics a, when temperature of the circuit, i.e. temperature of the board itself rises, the curve a changes to the curve b. Namely, output increases than usual in low input range but decreases than usual in high input range, thereby resulting in drop of sensitivity. If a measure of reduction of temperature drift in which a portion of wind from the fan is drawn towards the support 18 as in the present invention is not taken, detection results scatter, thus resulting in improper finished state of cooking.

### [INDUSTRIAL APPLICABILITY]

As described above in detail, since the detection circuit is constituted by the double-sided board, the front face and the rear face can be separately used as the signalling face and the grounding face, respectively. Thus, external electromagnetic field can be intercepted by the grounding face, so that the detection signal can be stabilized and thus, highly reliable detection can be performed.

Meanwhile, since the antenna is formed by the copper foil on the printed board, dimensional accuracy of the antenna is remarkably excellent, detection accuracy of microwave is also improved and wave data indicative of state of the food in the heating chamber can be detected accurately.

Furthermore, since the antenna and the detection circuit are formed on the identical board, accuracy in matching between the antenna and the detection circuit is excellent. Meanwhile, a transmission line connecting the antenna and the detection circuit can be made short and transmission loss characteristic of high frequency can be reduced. In addition, since a board used exclusively for the antenna is unnecessary, the production cost can be lowered and the size can be made compact.

Meanwhile, since the antenna and the detection circuit are constituted by the opposite faces of the identical board, wave leaking outwardly from the periphery of the antenna can be restricted by the grounding face of the detection circuit and thus, noises to operation of external apparatuses can be reduced. Meanwhile, since the antenna can be formed by using a portion of the rear face of the detection circuit, the size can be made compact substantially. Furthermore, since the detection circuit is disposed on one face of the board opposite to that of the antenna when wave is detected by the antenna, the elements on the detection circuit such as the diode, etc. are least likely to receive radiant heat, thus resulting in stable detection.

Meanwhile, since the periphery of the antenna is enclosed by the grounding face, wave leaking outwardly from vicinity of the antenna can be intercepted most efficiently and thus, production of noises affecting operation of external apparatuses can be restricted. On the contrary, the antenna is least likely to receive external noises and thus, stable detection can be continued. Furthermore, since matching state can be changed by width of a gap between the antenna and the grounding face, sensitivity can be changed freely. If width of the gap is set in accordance with a permissible input range of the detection circuit, a desired circuit input can be obtained easily.

Meanwhile, since the grounding face does not exist on the rear face of the antenna, a transmission line such as a line of 50 Ω is not required to be provided between the antenna and the detection circuit in contrast with general microstrip antennas, so that integral forming of the antenna and the detection circuit is facilitated. Meanwhile, it becomes unnecessary to form the antenna and the detection circuit on an identical face of the board.

Meanwhile, since the antenna and the detection circuit are connected to each other by the through-hole, connection accuracy is remarkably excellent and detection accuracy is improved.

Since the antenna is formed at the central portion of the board and is fixed, through the peripheral grounding face, to the heating chamber by the mounting jig, large length of the antenna can be secured relative to size of the board, so that quantity of detected wave is increased. Thus, even if there are scatters in mounting accuracy more or less, influence of the scatters can be lessened relatively. In other words, since size of the board may be made small for the antenna of an identical length, the expensive board for high frequency can be made compact, thereby resulting in great reduction of the production cost. Meanwhile, since the antenna is fixed in position by using the peripheral portion of the board, necessary mounting accuracy of the antenna can be obtained easily.

Meanwhile, since the antenna and the detection circuit are mounted through the metal support welded to the wall of the heating chamber, the grounding face can be positively short-circuited by the molded portions, mounting accuracy is excellent and impedance including the antenna and the detection circuit as observed from the heating chamber is stabilized. Furthermore, error factors for quantity of detected wave can be eliminated. Therefore, highly reliable detection can be performed. For the same reason, since the detection circuit can be so held as to be spaced a short distance from the wall of the heating chamber, various cooling means can be employed easily, so that rise of temperature of the detection circuit can be restricted and thus, reliability in heat resistance is also improved greatly. Meanwhile, since the antenna is less likely to directly receive substances scattered from the food, corrosion of the antenna or change of detection sensitivity due to water or oil from the food does not take place.

Meanwhile, since the antenna and the detection circuit are fixed in position to the heating chamber by soldering the grounding face of the board to the metal plate, short circuit point to earth can be secured and impedance including the antenna and the detection circuit as observed from the heating chamber is made constant. Thus, error factors for quantity of wave detected by the antenna can be obviated, thereby resulting in highly reliable detection.

Furthermore, since the metal plate is fastened to the support on the wall of the heating chamber by the machine screws, mechanical stress at the time of positioning of the detection circuit can be absorbed by the metal plate, so that excessive load is not applied to the detection circuit. Therefore, failures such as cutoff of the transmission line due to cracking of the board, etc. do not happen and thus, reliability of detection is improved.

Meanwhile, since the detection circuit is covered by the metal cover, influence of external electromagnetic field is intercepted and scatters of impedance due to variations of distance from outer metal parts are prevented, thereby resulting in stabilization of detection output.

Since the lead wire for fetching output of the detection circuit is fixed in position in the vicinity of its connecting portion with the detection circuit, scatters in mounting position of the lead wire can be eliminated and such an unstable factor is obviated that the lead wire carries or does not carry leakage current. In addition, since such a phenomenon does not take place that the lead wire comes close to the antenna so as to change state of matching between the antenna and the detection circuit or impedance obtained at the time when the antenna is observed from interior of the heating chamber, detection accuracy is quite excellent.

Since the coating is applied to the antenna, short circuit between the antenna and the wall of the heating chamber or other potential faces due to water or oil generated from the food and corrosion of the antenna do not take place and thus, stable detection performance can be provided.

Since the ventilation openings are formed on the support for the printed board so as to pass therethrough a portion of wind from the fan for cooling the wave irradiator, effect of heat dissipation is marked. Therefore, rise of temperature of the board can be restricted, so that detection performance of the detection circuit is stabilized and thus, detection accuracy is excellent without erroneous detection. Furthermore, since cool air passes through the ventilation openings at all times, steam (vapor) is least likely to be stored, so that formation of dews on the detection circuit is prevented and thus, a circuit further free from erroneous operation can be obtained.

## Claims

1. A high-frequency heating apparatus comprising:
a heating chamber (1) for accommodating a food (2);
a wave irradiator (3) for irradiating electromagnetic waves over the food so as to heat the food (2);
an antenna (6) positioned relative to said heating chamber (1) for receiving a portion (5) of the electromagnetic waves in the heating chamber other than those (4) absorbed by the food;
a detection circuit (7) connected to said antenna (6) for detecting the electromagnetic waves received by said antenna (6) and producing an output indicative of the received electromagnetic waves (5);
a controller (8) connected to said detection circuit (7) for controlling various operations of said apparatus in accordance with the output of said detection circuit (7);
characterized by
a printed board (11), said antenna (6) being formed by copper foil provided on said printed board (11), said printed board (11) further having a grounding face (23) of copper foil on the same face of said printed board (11) as said antenna (6) and surrounding and spaced from said antenna (6).

2. A high-frequency heating apparatus as claimed in claim 1 wherein the copper foil of said antenna (6) has a resist coating thereover.

3. A high-frequency heating apparatus as claimed in claim 1 wherein said antenna (6) is in the vicinity of the center of the printed circuit board (11), and further comprising a metal support (18) fixing said printed board (11) to said heating chamber (1) by mounting means extending through the grounding face (23) surrounding the antenna (6).

4. A high-frequency heating apparatus as claimed in claim 3 wherein said metal support (18) is welded to a wall of the heating chamber (1).

5. A high-frequency heating apparatus as claimed in claim 3 further comprising a metal plate (16), and said grounding face (23) of said printed board (11) is soldered to said metal plate (16), and said mounting means are machine screws (22) fastening said metal plate (16) to said metal support (18) on the wall of the heating chamber (1).

6. A high-frequency heating apparatus as claimed in claim 1 in which said antenna (6) and said detection circuit (7) are both mounted on a single circuit board (11).

7. A high-frequency heating apparatus as claimed in claim 6 wherein said board (11) has faces on opposite sides thereof and said antenna (6) and said detection circuit (7) are provided on respective opposite faces.

8. A high-frequency heating apparatus as claimed in claim 7 wherein said circuit board (11) has a hole (26) therethrough through which said antenna (6) is connected to said detection circuit (7).

## Patentansprüche

1. Hochfrequenzheizgerät mit
einer Heizkammer (1) zur Aufnahme eines Lebensmittels (2);
einer Bestrahlungsvorrichtung (3) zur Abgabe von elektromagnetischen Wellen auf das Lebensmittel (2), um es zu erwärmen;
einer Antenne (6), die gegenüber der Heizkammer (1) so angeordnet ist, daß sie einen Teil (5) der elektromagnetischen Wellen in der Heizkammer empfängt, der nicht wie ein anderer Teil (4) vom Lebensmittel aufgenommen wird;
einer Detektorschaltung (7), die an der Antenne (6) zum Feststellen der von der Antenne (6) empfangenen elektromagnetischen Wellen angeschlossen ist und ein Ausgangssignal erzeugt, das den empfangenen elektromagnetischen Wellen (5) entspricht;
einer Steuereinheit (8), die mit der Detektorschaltung (7) zur Steuerung verschiedener Betriebsvorgänge des Gerätes entsprechend dem Ausgangssignal der Detektorschaltung (7) verbunden ist,
dadurch gekennzeichnet,
daß eine gedruckte Schaltung (11) vorgesehen ist, auf der die Antenne (6) aus Kupferfolie ausgebildet ist;
daß eine Masse-Fläche (23) aus Kupferfolie auf derselben Oberfläche der gedruckten Schaltung (11) vorgesehen ist wie die Antenne (6) und die Antenne (6) umgibt, jedoch im Abstand von ihr angeordnet ist.

2. Hochfrequenzheizgerät nach Anspruch 1, bei der die Kupferfolie der Antenne (6) mit einem Schutzüberzug versehen ist.

3. Hochfrequenzheizgerät nach Anspruch 1, bei dem die Antenne (6) nahe der Mitte der gedruckten Schaltung (11) angeordnet ist und das eine metallene Halterung (18) enthält, die die gedruckte Schaltung (11) an der Heizkammer (1) über Befestigungsmittel befestigt, die durch die die Antenne (6) umgebende Masse-Fläche (23) hindurchreichen.

4. Hochfrequenzheizgerät nach Anspruch 3, bei dem die metallene Halterung (18) an einer Wand der Heizkammer (1) angeschweißt ist.

5. Hochfrequenzheizgerät nach Anspruch 3 mit einer Metallplatte (16), an der die Masse-Fläche (23) der gedruckten Schaltung (11) angelötet ist, und bei dem die Befestigungsmittel Maschinenschrauben (22) sind, die die Metallplatte (16) an der metallenen Halterung (18) an der Wand der Heizkammer (1) befestigen.

6. Hochfrequenzheizgerät nach Anspruch 1, bei dem die Antenne (6) und die Detektorschaltung (7) auf einer einzigen Schaltungsplatine (11) angeordnet sind.

7. Hochfrequenzheizgerät nach Anspruch 6, bei dem die Schaltungsplatine (11) Flächen auf einander gegenüberliegenden Seiten aufweist und die Antenne (6) und die Detektorschaltung (7) auf jeweils einander gegenüberliegenden Seiten angeordnet sind.

8. Hochfrequenzheizgerät nach Anspruch 7, bei dem die Schaltungsplatine (11) eine durch sie hindurchgehende Öffnung (26) aufweist, durch welche die Antenne (6) mit der Detektorschaltung (7) verbunden ist.

## Revendications

1. Appareil de chauffage à haute fréquence comportant :
une chambre de chauffage (1) pour recevoir un aliment (2) ;
un radiateur d'onde (3) pour rayonner des ondes électromagnétiques sur l'aliment de manière à chauffer l'aliment (2) ;
une antenne (6) disposée par rapport à ladite chambre de chauffage (1) pour recevoir une partie (5) des ondes électromagnétiques dans la chambre de chauffage autres que celles (4) absorbées par l'aliment ;
un circuit de détection (7) connecté à ladite antenne (6) pour détecter les ondes électromagnétiques reçues par ladite antenne (6) et produire un signal de sortie représentatif des ondes électromagnétiques reçues (5) ;
un contrôleur (8) relié audit circuit de détection (7) pour commander différentes opérations dudit appareil conformément au signal de sortie dudit circuit de détection (7) ;
caractérisé par
un circuit imprimé (11), ladite antenne (6) étant formée par une feuille de cuivre disposée sur ledit circuit imprimé (11), ledit circuit imprimé (11) possédant en outre une face de masse (23) de feuille de cuivre sur la même face dudit circuit imprimé (11) que ladite antenne (6) et entourant et espacée de ladite antenne (6).

2. Appareil de chauffage à haute fréquence selon la revendication 1, dans lequel la feuille de cuivre de ladite antenne (6) possède un revêtement de vernis.

3. Appareil de chauffage à haute fréquence selon la revendication 1, dans lequel ladite antenne (6) est disposée à proximité du centre de la carte de circuit imprimé (11), et comportant en outre un support métallique (18) fixant ledit circuit imprimé (11) à ladite chambre de chauffage (1) à l'aide de moyens de montage s'étendant à travers le face de masse (23) entourant l'antenne (6).

4. Appareil de chauffage à haute fréquence selon la revendication 3, dans lequel ledit support métallique (18) est soudé à une paroi de la chambre de chauffage (1).

5. Appareil de chauffage à haute fréquence selon la revendication 3, comportant en outre une plaque métallique (16), et ladite face de masse (23) dudit circuit imprimé (11) est soudée à ladite plaque métallique (16), et lesdits moyens de montage sont des vis (22) fixant ladite plaque métallique (16) audit support métallique (18) sur la paroi de la chambre de chauffage (1).

6. Appareil de chauffage à haute fréquence selon la revendication 1, dans lequel ladite antenne (6) et ledit circuit de détection (7) sont tous deux montés sur un unique circuit imprimé (11).

7. Appareil de chauffage à haute fréquence selon la revendication 6, dans lequel ledit circuit (11) possède des faces sur des côtés opposés de celui-ci et ladite antenne (6) et ledit circuit de détection (7) sont prévus sur des faces opposées respectives.

8. Appareil de chauffage à haute fréquence selon la revendication 7, dans lequel ledit circuit imprimé (11) possède un trou (26) le traversant par l'intermédiaire duquel ladite antenne (6) est connectée audit circuit de détection (7).
